# EUROPEAN PATENT APPLICATION

(11) **EP 4 529 364 A1**
(43) Date of publication of application: **26.03.2025**
(21) Application number: 23838395.4
(22) Date of filing: 01.02.2023
(51) Int. Cl.: H05K 1/02, H05K 9/00, H05K 1/11

(54) **CIRCUIT BOARD, CIRCUIT BOARD ASSEMBLY, AND ELECTRONIC DEVICE**

(30) Priority: 13.07.2022 CN 202221807585 U
(71) Applicant: Honor Device Co., Ltd., Shenzhen, Guangdong 518040 (CN)
(72) Inventor: SHI, Pengfei, Shenzhen, Guangdong 518040 (CN); YE, Peng, Shenzhen, Guangdong 518040 (CN); CAO, Chengzhuang, Shenzhen, Guangdong 518040 (CN); LIU, Yuhan, Shenzhen, Guangdong 518040 (CN)
(74) Representative: Beder, Jens
(86) International application number: PCT/CN2023/074153
(87) International publication number: WO 2024/011893

(57) **Abstract**

This application provides a circuit board, a circuit board assembly, and an electronic device, and relates to the field of electronic product technologies, to resolve a problem that space on a circuit board is wasted. Specifically, the circuit board includes a circuit board body, a first group of pads, and a second group of pads. The circuit board body includes a first surface. The first group of pads and the second group of pads are disposed on the first surface. The first group of pads is distributed along a first ring, the first group of pads is used for soldering a first shielding case, the first group of pads includes first pads, and the first pads are arranged on an edge that is of the first ring and that is close to the second group of pads. The second group of pads is distributed along a second ring, the second group of pads is used for soldering a second shielding case, the second group of pads includes second pads, and the second pads are arranged on an edge that is of the second ring and that is close to the first group of pads. The first pad and the second pad are an integral structural member. Therefore, a distance between originally adjacent pads is canceled, to facilitate miniaturization and ultra-thin development of the circuit board body.

## Description

This application claims priority to Chinese Patent Application No. 202221807585.4, filed with the China National Intellectual Property Administration on July 13, 2022 and entitled "CIRCUIT BOARD, CIRCUIT BOARD ASSEMBLY, AND ELECTRONIC DEVICE", which is incorporated herein by reference in its entirety.

### TECHNICAL FIELD

This application relates to the field of electronic product technologies, and in particular, to a circuit board, a circuit board assembly, and an electronic device.

### BACKGROUND

As an electronic product develops in a multi-function direction, a circuit board inside the electronic product has an increasingly tight area, and a distance between electronic components on the circuit board reaches a processing capability limit. Due to a limitation in a processing technology, a minimum spacing between shielding cases covering the electronic components needs to be 0.25 mm. Consequently, no other electronic components can be mounted due to an insufficient spacing between adjacent shielding cases, and a specific area of the circuit board is wasted. This is not conducive to high-density layout of electronic components on the circuit board.

### SUMMARY

Embodiments of this application provide a circuit board, a circuit board assembly, and an electronic device, to resolve a problem that space on the circuit board is wasted.

To achieve the foregoing objective, the following technical solutions are used in the embodiments of this application.

According to a first aspect, this application provides a circuit board. The circuit board includes a circuit board body, a first group of pads, and a second group of pads. The circuit board body includes a first surface. The first group of pads and the second group of pads are disposed on the first surface. The first group of pads is distributed along a first ring, the first group of pads is used for soldering a first shielding case, the first group of pads includes first pads, and the first pads are arranged on an edge that is of the first ring and that is close to the second group of pads. The second group of pads is distributed along a second ring, the second group of pads is used for soldering a second shielding case, the second group of pads includes second pads, and the second pads are arranged on an edge that is of the second ring and that is close to the first group of pads. The first pad and the second pad are an integral structural member.

The pads configured to be connected to the first shielding case and the second shielding case are disposed as an integral structural member. Therefore, a distance between originally adjacent pads is canceled, so that orthographic projection areas of the first pad and the second pad on the circuit board body are smaller. When the pad occupies a smaller area of the circuit board body, a larger quantity of electronic components can be mounted on the circuit board body per unit area, or a same quantity of electronic components can be disposed on a smaller circuit board body. Therefore, a layout area of the shielding case is further reduced, to facilitate miniaturization and ultra-thin development of the circuit board body.

In a possible implementation, a connection portion is disposed between the first pad and the second pad, the connection portion is disposed on the first surface, and the first pad, the second pad, and the connection portion are an integral structural member. A region of the connection portion is formed between the first pad and the second pad. In this way, when a first sidewall is soldered to the first pad, some solder may be accumulated on a side edge that is of a first flange portion and that is close to the connection portion, and the connection portion provides space for the accumulated solder. Similarly, when a second sidewall is soldered to the second pad, some solder may be accumulated on a side edge that is of a second flange portion and that is close to the connection portion, and the connection portion provides space for the accumulated solder. The accumulated solder on the first flange portion helps improve connection strength between the first sidewall and the first pad. Similarly, the accumulated solder on the second flange portion helps improve connection strength between the second sidewall and the second pad.

In a possible implementation, a solder resist layer is disposed on a surface that is of the connection portion and that faces away from the circuit board body. The solder resist layer may be covered with green oil or disposed as bare copper. Solder is not prone to be accumulated at the solder resist layer. In a soldering process, solder that is squeezed out is not accumulated on the connection portion, and the molten solder flows to the first pad and the second pad on two sides of the connection portion. Finally, accumulated solder is formed on the side edge of the first flange portion and the side edge of the second flange portion. The solder resist layer is disposed, to help form an accumulated solder effect, so as to further improve the connection strength between the first sidewall and the first pad and the connection strength between the second sidewall and the second pad.

In a possible implementation, there are a plurality of first pads and a plurality of second pads, the plurality of first pads are distributed at intervals along the edge that is of the first ring and that is close to the second group of pads, and the plurality of second pads are distributed at intervals along the edge that is of the second ring and that is close to the first group of pads. A quantity of first pads is equal to a quantity of second pads, the plurality of first pads are in a one-to-one correspondence with the plurality of second pads, and a first pad and a second pad that correspond to each other are an integral structural member. In an arrangement direction of the first group of pads and the second group of pads, orthographic projections of a first pad and a second pad that are correspondingly disposed overlap. The plurality of first pads and the plurality of second pads are disposed, so that a plurality of connection points can be added to fasten the first shielding case and the second shielding case. Specifically, the first shielding case is connected to the plurality of first pads through the first sidewall, and the second shielding case is connected to the plurality of second pads through the second sidewall. Strength of connecting the first shielding case and the second shielding case to the circuit board body is improved by implementing connections to the plurality of first pads and the plurality of second pads.

In a possible implementation, a whole obtained by connecting the first pad and the second pad is a shared pad. In the arrangement direction of the first group of pads and the second group of pads, a width of the shared pad is greater than or equal to 0.5 mm and less than or equal to 0.9 mm. The width of the shared pad is greater than or equal to 0.5 mm, and therefore the shared pad provides a sufficient connection area for the first shielding case and the second shielding case, to ensure connection strength between the first shielding case and the first pad and connection strength between the second shielding case and the second pad. In addition, the width of the shared pad is less than or equal to 0.9 mm, which breaks through an existing limit of 1.05 mm while ensuring connection strength between the first shielding case and the second shielding case. This is conducive to miniaturization and thinness and lightness development of the circuit board body.

According to a second aspect, in a possible implementation, a circuit board assembly is provided. The circuit board assembly includes the foregoing circuit board, a first shielding case, and a second shielding case. The first shielding case is connected to a first group of pads. The second shielding case is connected to a second group of pads.

The circuit board assembly provided in this embodiment of this application includes the circuit board in any one of the foregoing technical solutions. Therefore, the circuit board assembly and the circuit board can resolve a same technical problem and achieve same effects.

According to a third aspect, a circuit board assembly includes a circuit board body, a first group of pads, a second group of pads, a first shielding case, and a second shielding case. The circuit board body includes a first surface. The first group of pads and the second group of pads are disposed on the first surface. The first group of pads is distributed along a first ring, the first group of pads includes first pads, and the first pads are arranged on an edge that is of the first ring and that is close to the second group of pads. The second group of pads and the first pad are distributed along a second ring. The first shielding case includes a first sidewall, and the first sidewall forms a sidewall that is of the first shielding case and that is close to the second group of pads. The first sidewall includes a first main body portion and a first flange portion, and the first flange portion is located on an outer surface that is of the first main body portion and that is close to one end of the first pad. The first main body portion and the first flange portion are connected to the first pad. The second shielding case includes a second sidewall, and the second sidewall forms a sidewall that is of the second shielding case and that is close to the first sidewall. The second sidewall is at least partially located on a side that is of the first connection portion and that is back-to-back with the first pad, and is at least partially connected to the first flange portion.

The first shielding case is connected to the first pad through the first sidewall, and the second shielding case is connected to a surface that is of the first flange portion and that is far away from the first pad through the second sidewall. An area that is of the second shielding case and that is soldered to a second pad is saved, and an original transverse area is converted to a longitudinal direction. The first sidewall and the second sidewall are connected to the circuit board body only through the first pad. In this way, an area that is of the circuit board body and that is occupied by the pad is reduced. A larger quantity of electronic components can be mounted on the circuit board body per unit area, or a same quantity of electronic components can be disposed on a smaller circuit board body. Therefore, a layout area of the shielding case is further reduced, to facilitate miniaturization and ultra-thin development of the circuit board body.

In a possible implementation, the second sidewall includes a second main body portion and a second flange portion, and the second flange portion is located on an outer surface that is of the second main body portion and that is close to one end of the first pad. On the second sidewall, the second flange portion is at least partially located on the side that is of the first flange portion and that is back-to-back with the first pad, and the second flange portion is at least partially connected to the first flange portion.

The second sidewall is connected to the first sidewall by connecting the second flange portion to the first flange portion. The second flange portion provides a larger connection area for the connection between the second sidewall and the first sidewall, to improve connection strength of the second shielding case, so that the circuit board assembly has higher stability. The second pad configured to be connected to the second sidewall is canceled on the circuit board body, and the second sidewall is directly connected to a surface that is of the first sidewall and that is far away from the first pad. In this way, an area that is of the circuit board body and that is occupied by the pad is reduced. Therefore, a layout area of the shielding case 33 is further reduced, to facilitate miniaturization and ultra-thin development of the circuit board body.

In a possible implementation, both the second main body portion and the second flange portion are located on the side that is of the first flange portion and that is back-to-back with the first pad, and both the second main body portion and the second flange portion are connected to the first flange portion. The second sidewall is connected to the first sidewall by connecting both the second main body portion and the second flange portion to the first flange portion. The second main body portion and the second flange portion provide a larger connection area for the connection between the second sidewall and the first sidewall, to improve the connection strength of the second shielding case, so that the circuit board assembly has higher stability. This further reduces a layout area of the shielding case, to facilitate miniaturization and ultra-thin development of the circuit board body.

In a possible implementation, there are a plurality of first pads, and the plurality of first pads are distributed at intervals along the edge that is of the first ring and that is close to the second group of pads. The plurality of first pads are disposed, so that a plurality of connection points can be added to fasten the first shielding case. Specifically, the first shielding case is connected to the plurality of first pads through the first sidewall. Strength of connecting the first shielding case to the circuit board body is improved by implementing a connection to the plurality of first pads. The first sidewall of the first shielding case provides sufficient connection strength for the second shielding case, so that the first shielding case and the second shielding case are more stably fastened.

In a possible implementation, in an arrangement direction of the first group of pads and the second group of pads, a width of the first pad is greater than or equal to 0.7 mm and less than or equal to 0.85 mm. The width of the first pad is greater than or equal to 0.7 mm, and therefore the first pad provides a sufficient connection area for the first sidewall of the first shielding case, and is sufficient to meet an extension area that is of the first flange portion and that is used to be connected to the second sidewall. Therefore, the width of the first pad may ensure connection strength between the first shielding case and the first pad and connection strength between the second shielding case and the first flange portion. The width of the first pad is less than or equal to 0.85 mm, which breaks through an existing limit of 0.9 mm while ensuring connection strength between the first shielding case and the second shielding case. This is conducive to miniaturization and thinness and lightness development of the circuit board body.

According to a fourth aspect, a circuit board assembly is provided. The circuit board assembly includes a circuit board body, a first group of pads, a second group of pads, a first shielding case, and a second shielding case. The circuit board body includes a first surface. The first group of pads and the second group of pads are disposed on the first surface. The first group of pads is distributed along a first ring, the first group of pads includes first pads, and the first pads are arranged on an edge that is of the first ring and that is close to the second group of pads. The second group of pads is distributed along a second ring, the second group of pads includes second pads, and the second pads are arranged on an edge that is of the second ring and that is close to the first group of pads. The edge that is of the first ring and that is close to the second group of pads overlaps the edge that is of the second ring and that is close to the first group of pads to form an overlapping edge, and the first pads and the second pads are alternately disposed along the overlapping edge.

The first shielding case includes a first sidewall, and the first sidewall forms a sidewall that is of the first shielding case and that is close to the second group of pads. The first sidewall includes a first main body portion and a first flange portion, and a plurality of first flange portions are located on an outer surface that is of the first main body portion and that is close to one end of the first pad. The first flange portion includes first convex portions and first concave portions, the first convex portions and the first concave portions are alternately disposed along the overlapping edge, and the first pad is at least partially opposite to and connected to the first convex portion.

The second shielding case includes a second sidewall, and the second sidewall forms a sidewall that is of the second shielding case and that is close to the first group of pads. The second sidewall includes a second main body portion and a second flange portion, and a plurality of second flange portions are located on an outer surface that is of the second main body portion and that is close to one end of the second pad. The second flange portion includes second convex portions and second concave portions, the second convex portions and the second concave portions are alternately disposed along the overlapping edge, and the second pad is at least partially opposite to and connected to the second convex portion.

Sidewalls that are of the first shielding case and the second shielding case and that are located on the overlapping edge are disposed in a concave-convex shape, and the first shielding case and the second shielding case are fastened by connecting the convex portions to the pads. Specifically, the first shielding case is connected to the first pad through the first convex portion, and the second shielding case is connected to the second pad through the second convex portion. In addition, the first pads and the second pads are alternately disposed, and a first pad and a second pad that originally need to be correspondingly disposed on two sides of the overlapping edge are canceled. Therefore, a total quantity of first pads and second pads is reduced. When the pad occupies a smaller area of the circuit board body, a larger quantity of electronic components can be mounted on the circuit board body per unit area, or a same quantity of electronic components can be disposed on a smaller circuit board body. Therefore, a layout area of the shielding case is further reduced, to facilitate miniaturization and ultra-thin development of the circuit board body.

In a possible implementation, the first pad includes a first region and a second region. The first region is opposite to and connected to the first convex portion, and the second region is opposite to and connected to an edge that is of the second flange portion and on which the second concave portion is formed. The first sidewall is connected to the first region of the first pad through the first convex portion, and the second sidewall is connected to the second region of the first pad through the second concave portion. That is, the second shielding case is connected to the second pad through the second convex portion, and may be further connected to the first pad through the second concave portion. A connection area of the second shielding case is further increased, so that the second shielding case is more stably connected, to further improve stability of the circuit board assembly. In addition, the second shielding case is connected to the first pad only through the second concave portion. In this way, an area that is of the first pad and that is reserved for being connected to the second shielding case is reduced, and an area that is of the circuit board body and that is occupied by the first pad is reduced. Therefore, a layout area of the shielding case is further reduced, to facilitate miniaturization and ultra-thin development of the circuit board body.

In a possible implementation, the second pad includes a third region and a fourth region. The third region is opposite to and connected to the second convex portion, and the fourth region is opposite to and connected to an edge that is of the first flange portion and on which the first concave portion is formed. The second sidewall is connected to the third region of the second pad through the second convex portion, and the first sidewall is connected to the fourth region of the second pad through the first concave portion. That is, the first shielding case is connected to the first pad through the first convex portion, and may be further connected to the second pad through the first concave portion. A connection area of the first shielding case is further increased, so that the first shielding case is more stably connected, to further improve stability of the circuit board assembly. In addition, the first shielding case is connected to the second pad only through the first concave portion. In this way, an area that is of the second pad and that is reserved for being connected to the first shielding case is reduced, and an area that is of the circuit board body and that is occupied by the second pad is reduced. Therefore, a layout area of the shielding case is further reduced, to facilitate miniaturization and ultra-thin development of the circuit board body.

In a possible implementation, the first concave portion extends to the first main body portion and runs through the first flange portion and the first main body portion; and the second concave portion extends to the second main body portion and runs through the second flange portion and the second main body portion. In a direction perpendicular to the first surface, a distance between the first concave portion and the first surface is greater than a height between the first convex portion and the first surface, and a distance between the second concave portion and the first surface is greater than a height between the second convex portion and the first surface. When the first shielding case and the second shielding case are connected to the circuit board body, the first concave portion may be directly disposed on a surface that is of the second convex portion and that is far away from the second pad, and the second concave portion may be directly disposed on a surface that is of the first convex portion and that is far away from the first pad. A width that is of the first pad and that is reserved for being connected to the second concave portion and a width that is of the second pad and that is reserved for being connected to the first concave portion are further saved. In this way, the area that is of the circuit board body and that is occupied by each of the first pad and the second pad is further reduced. Therefore, a layout area of the shielding case is further reduced, to facilitate miniaturization and ultra-thin development of the circuit board body.

In a possible implementation, a first soldering material is disposed in a part that is of the first concave portion and that is located between the first main body portion and the second pad; and a second soldering material is disposed in a part that is of the second concave portion and that is located between the second main body portion and the first pad. A gap between the first concave portion and the second pad is filled by using the first soldering material, and a gap between the second concave portion and the first pad is filled by using the second soldering material. In this way, closed accommodation cavities are formed in the first shielding case and the second shielding case, and a first electronic component and a second electronic component are respectively accommodated in the first shielding case and the second shielding case. The closed accommodation cavities formed in the first shielding case and the second shielding case better shield an interference signal, to ensure that the electronic components are not affected by the interference signal.

In a possible implementation, a third soldering material is disposed between the first main body portion and the second main body portion. The third soldering material further fills a gap between the first shielding case and the second shielding case, to better ensure that the electronic components are not affected by the interference signal.

In a possible implementation, the third soldering material and each of the first soldering material and the second soldering material are an integral structural member. The third soldering material may be a part that is of the first soldering material and that is squeezed between the first main body portion and the second main body portion, or may be a part that is of the second soldering material and that is squeezed between the first main body portion and the second main body portion. In a production process, a solder spot-coating process needs to be performed only based on this, and the first main body portion and the second main body portion do not need to be specifically spot-coated with solder. This is more efficient and faster in a process procedure.

In a possible implementation, in an arrangement direction of the first group of pads and the second group of pads, a width of the first pad and a width of the second pad are greater than or equal to 0.5 mm and less than or equal to 0.9 mm. The width of the first pad and the width of the second pad are greater than or equal to 0.5 mm, and therefore the width of the first pad and the width of the second pad provide a sufficient connection area for the first shielding case and the second shielding case. In addition, the width of the first pad and the width of the second pad are less than or equal to 0.9 mm, which breaks through an existing limit of 1.05 mm while ensuring connection strength between the first shielding case and the second shielding case. This is conducive to miniaturization and thinness and lightness development of the circuit board body.

According to a fifth aspect, an electronic device is provided, and includes a housing and the circuit board assembly according to any one of the foregoing implementations. The circuit board assembly is disposed in the housing.

The electronic device provided in this embodiment of this application includes the circuit board assembly in any one of the foregoing technical solutions. Therefore, the electronic device and the circuit board assembly can resolve a same technical problem and achieve same effects.

### BRIEF DESCRIPTION OF DRAWINGS

FIG. 1 is a three-dimensional view of an electronic device according to some embodiments of this application;
FIG. 2 is an exploded view of the electronic device shown in FIG. 1;
FIG. 3 is a schematic diagram of a cross-sectional structure of a rear housing in FIG. 2 along a line A-A;
FIG. 4 is a schematic diagram of a structure of a circuit board assembly according to some embodiments of this application;
FIG. 5 is a schematic diagram of a structure of a circuit board assembly according to some embodiments of this application;
FIG. 6 is a schematic diagram of a cross-sectional structure of the circuit board assembly in FIG. 5 along a line B-B;
FIG. 7 is a schematic diagram of a structure of a circuit board assembly in a production process according to some embodiments of this application;
FIG. 8 is a schematic diagram of a structure of a steel mesh according to some embodiments of this application;
FIG. 9 is a schematic diagram of a structure of a circuit board assembly according to some embodiments of this application;
FIG. 10 is a schematic diagram of a cross-sectional structure of the circuit board assembly in FIG. 9 along a line C-C;
FIG. 11 is an enlarged view of a region A in FIG. 10;
FIG. 12 is a schematic diagram of a structure of a circuit board according to some embodiments of this application;
FIG. 13 is an enlarged view of a region B in FIG. 12;
FIG. 14 is an enlarged view of a region C in FIG. 12;
FIG. 15 is a schematic diagram of a structure of a circuit board assembly according to some embodiments of this application;
FIG. 16 is an enlarged view of a region D in FIG. 15;
FIG. 17 is another enlarged view of a region D in FIG. 15;
FIG. 18 is another enlarged view of a region D in FIG. 15;
FIG. 19 is a schematic diagram of a structure of a circuit board assembly according to some embodiments of this application;
FIG. 20 is an enlarged view of a region E in FIG. 19;
FIG. 21 is a schematic diagram of a structure of a circuit board according to some embodiments of this application;
FIG. 22 is an enlarged view of a region G in FIG. 21;
FIG. 23 is a schematic diagram of a structure of a first shielding case and a second shielding case according to some embodiments of this application; and
FIG. 24 is an enlarged view of a region E in FIG. 19.

### DESCRIPTION OF EMBODIMENTS

In some embodiments, the terms "first", "second", "third", and "fourth" are used for descriptive purposes only, and cannot be construed as indicating or implying relative importance or implicitly indicating a quantity of indicated technical features. Therefore, features defined with "first", "second", "third" and "fourth" may explicitly or implicitly include one or more such features.

In some embodiments, the term "include", "comprise", or any other variant thereof is intended to cover non-exclusive inclusion, so that a process, method, article, or apparatus that includes a series of elements includes not only those elements, but also includes other elements that are not explicitly listed, or includes elements inherent to such a process, method, article, or apparatus. Without further limitation, an element defined by the sentence "including a..." does not exclude existence of other identical elements in the process, method, article, or apparatus including the element.

It should be understood that the foregoing orientation or positional relationship indicated by a term such as "inside" or "outside" is an orientation or positional relationship shown based on the accompanying drawings, is merely intended for ease of describing the present utility model and simplifying description, and is not intended to indicate or imply that a specified apparatus or element needs to have a specific orientation or be constructed and operated in a specific orientation, and therefore cannot be construed as a limitation on the present utility model. The orientation terms "inside" and "outside" are the inside and outside relative to an outline of each part.

This application provides an electronic device. The electronic device is a type of electronic device with a circuit board. The electronic device may be user equipment (user equipment, UE), a terminal device (terminal), or the like. For example, the electronic device may be a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a terminal in industrial control (industrial control), a terminal in self driving (self driving), a terminal in remote medical (remote medical), a terminal in a smart grid (smart grid), a terminal in transportation safety (transportation safety), a terminal in a smart city (smart city), or a terminal in a smart home (smart home). The large-screen display terminal includes but is not limited to a device such as a smart screen, a portable android device (portable android device, PAD), a notebook computer, a desktop computer, a television, or a projector.

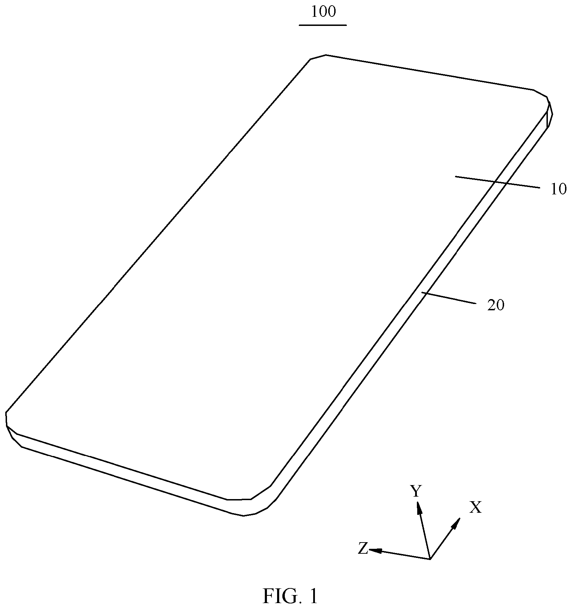

Refer to FIG. 1. FIG. 1 is a three-dimensional view of an electronic device 100 according to some embodiments of this application. In this embodiment and the following embodiments, an example in which the electronic device 100 is a mobile phone is used for description. The electronic device 100 is approximately in a rectangular plate shape. Based on this, for ease of description in the following embodiments, an XYZ coordinate system is established, a width direction of the electronic device 100 is defined as a Z-axis direction, a length direction of the electronic device 100 is defined as an X-axis direction, and a thickness direction of the electronic device 100 is defined as a Y-axis direction. It may be understood that the coordinate system of the electronic device 100 may be flexibly set based on an actual requirement. This is not specifically limited herein. In some other embodiments, a shape of the electronic device 100 may alternatively be a square flat plate, a circular flat plate, an elliptical flat plate, or the like. This is not specifically limited herein.

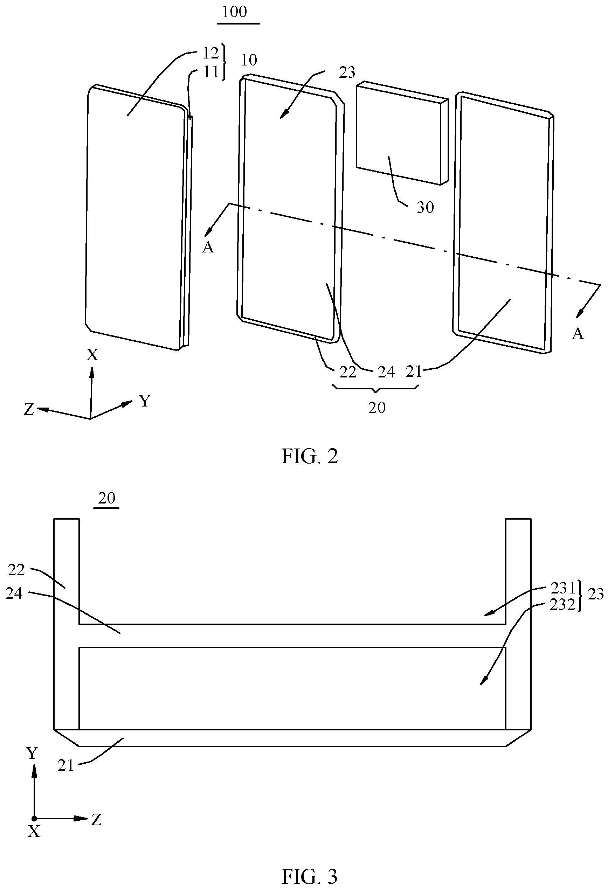

Refer to FIG. 1 and FIG. 2. FIG. 2 is an exploded view of the electronic device 100 shown in FIG. 1. In this embodiment, the electronic device 100 includes a display 10 and a rear housing 20.

It may be understood that FIG. 1 and FIG. 2 show only an example of some parts included in the electronic device 100. Actual shapes, actual sizes, actual positions, and actual constructions of these parts are not limited by those in FIG. 1 and FIG. 2.

Refer to FIG. 2. The display 10 is configured to display an image, a video, and the like. The display 10 includes a light-transmitting cover plate 12 and a display module 11. The light-transmitting cover plate 12 and the display module 11 are stacked. The light-transmitting cover plate 12 is mainly configured to protect the display module 11 and prevent dust. A material of the light-transmitting cover plate 12 includes but is not limited to glass. When a user uses the electronic device 100, the light-transmitting cover plate 12 faces the user. The light-transmitting cover plate 12 has functions such as impact resistance, scratch resistance, oil resistance, fingerprint resistance, and light transmittance enhancement.

The display module 11 may be a flexible display, or may be a rigid display. For example, the display module 11 includes a display panel, and the display panel may be an organic light-emitting diode (organic light-emitting diode, OLED) display panel, an active-matrix organic light-emitting diode (active-matrix organic light-emitting diode, AMOLED) display panel, a mini light-emitting diode (mini organic light-emitting diode) display panel, a micro light-emitting diode (micro organic light-emitting diode) display panel, a micro organic light-emitting diode (micro organic light-emitting diode) display panel, a quantum dot light emitting diode (quantum dot light emitting diodes, QLED) display panel, or a liquid crystal display (liquid crystal display, LCD).

Continue to refer to FIG. 2. The rear housing 20 forms a housing of the electronic device 100, and is configured to protect an electronic component in the electronic device 100. The rear housing 20 may include a back cover 21 and a frame 22. The back cover 21 is located on a side that is of the display module 11 and that is far away from the light-transmitting cover plate 12, and is stacked with and disposed at intervals from the light-transmitting cover plate 12 and the display module 11. The frame 22 is located between the back cover 21 and the light-transmitting cover plate 12. The frame 22 is fastened to the back cover 21. For example, the frame 22 may be fixedly connected to the back cover 21 by using adhesive. Alternatively, the frame 22 and the back cover 21 may be of an integrally formed structure, that is, the frame 22 and the back cover 21 are an integral structural member. The light-transmitting cover plate 12 is fastened to the frame 22 by using adhesive. The light-transmitting cover plate 12, the back cover 21, and the frame 22 enclose to form an accommodation cavity 23 of the electronic device 100. The accommodation cavity 23 accommodates components such as the display module 11, a circuit board, a camera, and a flash.

Refer to FIG. 3. FIG. 3 is a schematic diagram of a cross-sectional structure of the rear housing 20 in FIG. 2 along a line A-A. In some embodiments, the rear housing 20 further includes a middle plate 24. The middle plate 24 is disposed in the accommodation cavity 23, and the middle plate 24 is located on the side that is of the display module 11 and that is far away from the light-transmitting cover plate 12. An edge of the middle plate 24 is fastened to the frame 22. In some embodiments, the edge of the middle plate 24 is fastened to the frame 22 by using adhesive. Alternatively, the middle plate 24 and the frame 22 may be of an integrally formed structure, that is, the middle plate 24 and the frame 22 are an integral structural member. The middle plate 24 separates the accommodation cavity into a first accommodation groove 231 and a second accommodation groove 232, and the display module 11 is located in the first accommodation groove 231. Other electronic elements are disposed in the second accommodation groove 232, for example, a battery and a circuit board assembly. The back cover 21 is fastened to the frame 22 by using foam tape.

In some embodiments, the circuit board assembly 30 is disposed in the second accommodation groove 232, the circuit board assembly 30 is configured to implement electrical connections between a plurality of functional components, and the circuit board assembly 30 is configured to perform operations such as signal control, data signal processing, and data signal storage on the functional component. The circuit board assembly 30 may be a main board of the electronic device 100, or may be another circuit board of the electronic device 100, for example, a circuit board that is in the mobile phone and that is configured to carry a speaker (speaker) and a USB interface. This is not specifically limited herein. In this application, an example in which the circuit board assembly 30 is a circuit board of the electronic device 100 is used for description. This should not be considered as a special limitation on this application.

In some embodiments, the functional component is disposed in the second accommodation groove 232, and the functional component is configured to implement one or more functions of the electronic device 100. The functional component includes but is not limited to a camera module, a display, a speaker, a receiver, an antenna, a microphone, a universal serial bus (universal serial bus, USB) interface, a subscriber identification module (subscriber identification module, SIM) card interface, a key, and the like.

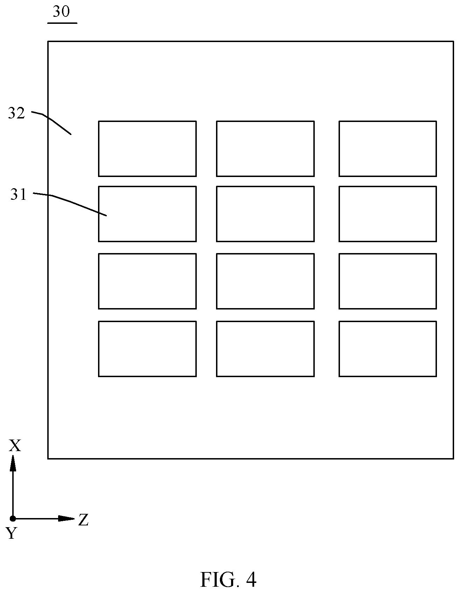

Refer to FIG. 4. FIG. 4 is a schematic diagram of a structure of a circuit board assembly 30 according to some embodiments of this application. Specifically, the circuit board assembly 30 includes an electronic component 31 and a circuit board body 32, and the electronic component 31 is connected to the circuit board body 32.

The electronic component 31 includes but is not limited to a chip, a resistor, a capacitor, an inductor, a potentiometer, an electron tube, a heat sink, an electromechanical element, a connector, a semiconductor discrete device, a sensor, a power supply, a switch, a small and special electrical machine, an electronic transformer, a relay, and the like. A plurality of spaced-apart pin terminals are disposed on the electronic component 31. It should be noted that a quantity and an arrangement manner of electronic components 31 in this embodiment of this application may be set based on an actual requirement. The quantity and the arrangement manner of electronic components 31 are not limited in this embodiment of this application.

The circuit board body 32 includes but is not limited to a printed circuit board (printed circuit board, PCB) and a flexible printed circuit (flexible printed circuit, FPC) board. In this embodiment and the following embodiments, an example in which the circuit board body 32 is a PCB board is used for description. A shape of the circuit board body 32 includes but is not limited to a rectangle, a square, a polygon, a circle, or the like. In the embodiment shown in FIG. 4, the shape of the circuit board body 32 is a rectangle.

The circuit board body 32 includes metal layers and insulation dielectric layers that are sequentially alternately disposed. The metal layer includes a signal line and/or a metal reference plane. In the circuit board body 32, signal lines at different metal layers are connected through a metallized via. The circuit board body 32 is configured to carry the electronic component 31, and is electrically connected to the electronic component 31. Specifically, a plurality of spaced-apart pads are disposed at the insulation dielectric layer of the circuit board body 32. The plurality of pads are configured to be soldered to the plurality of pin terminals, to connect the electronic component 31 to the circuit board body 32. A shape of the pad includes but is not limited to a rectangle, a square, a polygon, a circle, an ellipse, a special shape, or the like. The plurality of pads may be arranged in an array. Certainly, the plurality of pads may be irregularly arranged.

A soldering material, for example, solder paste, is disposed on the pad of the circuit board body 32. The pin terminal of the electronic component 31 is soldered to the pad by using the soldering material, and the soldering material is heated and molten, so that the pad and the pin terminal are soldered as a whole, to solder the electronic component 31 to the circuit board body 32.

In a process of using the circuit board assembly 30, the electronic component 31 may be interfered with by an external signal and by a signal sent by an adjacent electronic component 31. If the interference is excessively strong, normal working of the electronic component 31 is affected, and further normal working of the electronic device 100 is affected.

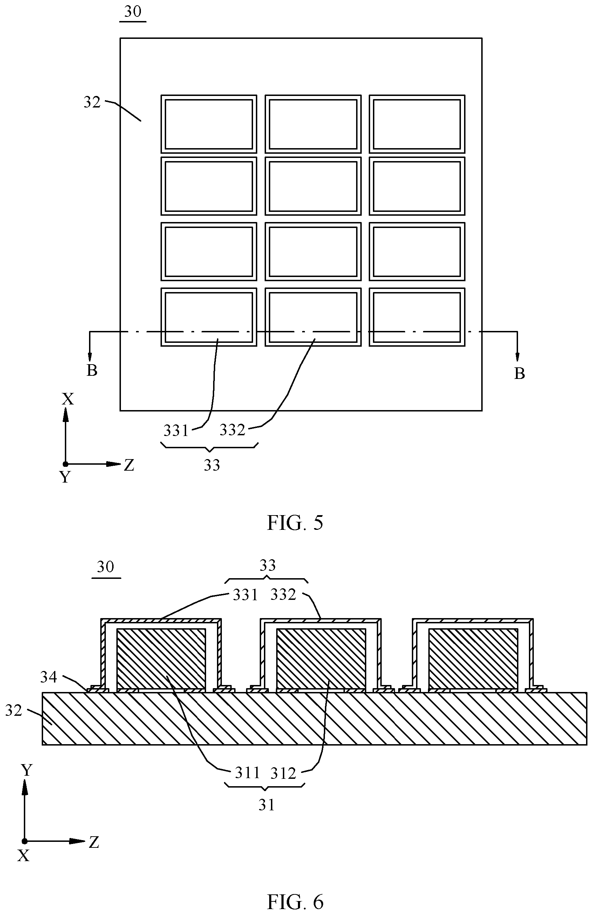

Refer to FIG. 5 and FIG. 6. FIG. 5 is a schematic diagram of a structure of a circuit board assembly 30 according to some embodiments of this application, and FIG. 6 is a schematic diagram of a cross-sectional structure of the circuit board assembly 30 in FIG. 5 along a line B-B. To resolve the foregoing problem, a shielding case 33 is disposed on the circuit board body 32, and the shielding case 33 is configured to accommodate the electronic component 31. The shielding case 33 is connected to a surface of the circuit board body 32 through a pad 34. A soldering material, for example, solder paste, is disposed on the pad 34. The shielding case 33 is soldered to the pad 34 by using the soldering material, and the soldering material is heated and molten, to solder the shielding case 33 to the circuit board body 32.

When the circuit board assembly 30 works, the electronic component 31 sends an interference signal to a surrounding region. When the interference signal encounters the shielding case 33, a part is reflected back, and a part is absorbed by the shielding case 33, so that the interference signal terminates on a surface of the shielding case 33. Similarly, when arriving at the shielding case 33, an interference signal transmitted by an external electronic component 31 is also shielded, so that there is no mutual interference between the electronic components 31.

Continue to refer to FIG. 6. In some embodiments, there are at least two electronic components 31. Specifically, the electronic components 31 may include a first electronic component 311 and a second electronic component 312 that are disposed adjacent to each other. Correspondingly, there are at least two shielding cases 33. Specifically, the shielding cases 33 may include a first shielding case 331 and a second shielding case 332. The first shielding case 331 is configured to accommodate the first electronic component 311, and the first shielding case 331 shields, within the first shielding case 331, an interference signal sent by the first electronic component 311, and shields an external interference signal outside the first shielding case 331, to ensure that the first electronic component 311 is not affected by the interference signal.

Similarly, the second shielding case 332 is configured to accommodate the second electronic component 312, and the second shielding case 332 shields, within the second shielding case 332, an interference signal sent by the second electronic component 312, and shields an external interference signal outside the second shielding case 332, to implement that the second electronic component 312 is not affected by the interference signal.

The electronic device 100 tends to be ultra-thin and miniaturized. Therefore, when the circuit board assembly 30 is produced, the electronic component 31 is arranged in a compact manner on the surface of the circuit board body 32, to avoid a problem of space waste caused by excessive blank space on the surface of the circuit board body 32. The shielding case 33 is also arranged in a compact manner with the electronic component 31 on the circuit board body 32. Therefore, a spacing between adjacent shielding cases 33 is correspondingly reduced. On the surface of the circuit board body 32, a spacing between adjacent pads 34 used for soldering the shielding case 33 is also correspondingly reduced.

However, due to a limitation in a production process, a shortest distance between the adjacent pads 34 can only be 0.25 mm. A gap between the adjacent pads 34 wastes space on the surface of the circuit board body 32. Therefore, the limit of 0.25 mm needs to be broken through to make the spacing between the adjacent pads 34 smaller.

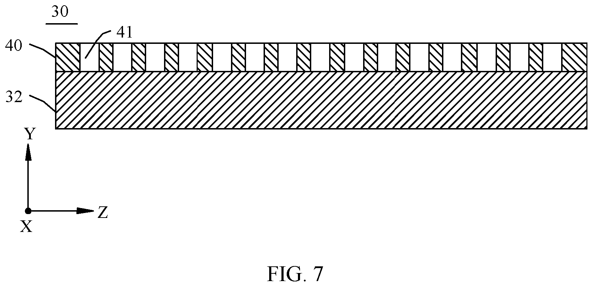

Continue to refer to FIG. 7. FIG. 7 is a schematic diagram of a structure of a circuit board assembly 30 in a production process according to some embodiments of this application. The limitation in the production process means that in a process of producing the circuit board assembly 30, the pad 34 is disposed on the surface of the circuit board body 32 by using a steel mesh 40, and an opening 41 of the steel mesh 40 limits the distance between the adjacent pads 34.

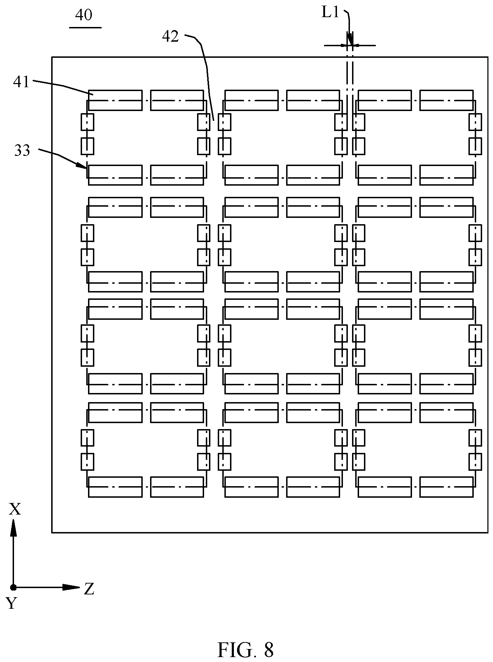

Continue to refer to FIG. 8. FIG. 8 is a schematic diagram of a structure of a steel mesh 40 according to some embodiments of this application. Specifically, a shape of the steel mesh 40 is set to a shape consistent with that of the circuit board body 32, and a plurality of openings 41 are disposed at intervals on a surface of the steel mesh 40. The opening 41 is a through hole that runs through a body of the steel mesh 40, and the plurality of openings 41 are distributed along a ring, for example, a circular ring or a square ring. A shape of the ring is consistent with that of the shielding case 33.

When the pad 34 is manufactured on the surface of the circuit board body 32, the steel mesh 40 is first bonded and disposed on the surface of the circuit board body 32. The surface of the steel mesh 40 is covered with molten solder, and the molten solder flows into the surface of the circuit board body 32 through the opening 41 of the steel mesh 40. Excess molten solder on the surface of the steel mesh 40 is scraped by using a scraper. In a scraping process, the excess solder may be removed, and the molten solder may be squeezed into an opening 41 that is not fully filled, to ensure formation of the pad 34 at the opening 41. Finally, the molten solder is cooled on the surface of the circuit board body 32 to form the pad 34.

In the foregoing process, the steel mesh 40 needs to have specific structural strength, to ensure formation of the pad 34 at the opening 41. The steel mesh 40 between openings 41 forms a physical portion 42. If a spacing between adjacent openings 41 is relatively small, the physical portion 42 has a relatively high risk of being bent and deformed, and a formation effect of the pad 34 is affected. Therefore, to ensure structural strength of the physical portion 42, a shortest distance L1 between the adjacent openings 41 can only be 0.25 mm.

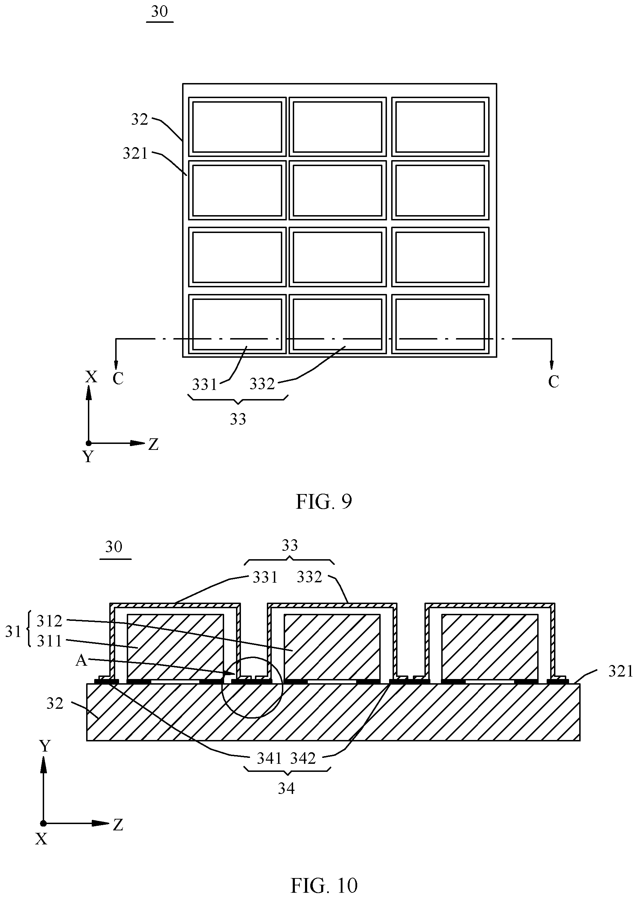

Refer to FIG. 9 and FIG. 10. FIG. 9 is a schematic diagram of a structure of a circuit board assembly 30 according to some embodiments of this application, and FIG. 10 is a schematic diagram of a cross-sectional structure of the circuit board assembly 30 in FIG. 9 along a line C-C. To resolve the foregoing problem, adjacent shielding cases 33 are soldered to a same pad 34, to reduce a spacing between adjacent pads 34. Specifically, the circuit board assembly 30 includes a circuit board body 32, a first group of pads 341, a second group of pads 342, a first shielding case 331, and a second shielding case 332.

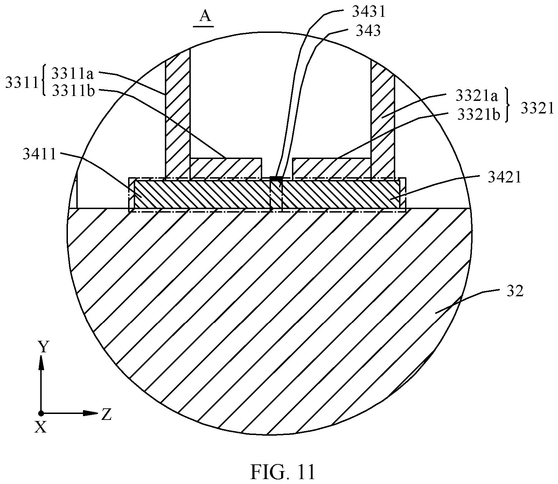

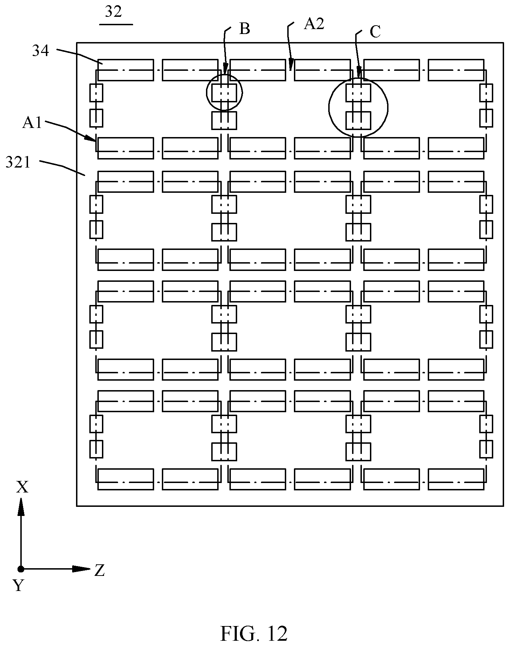

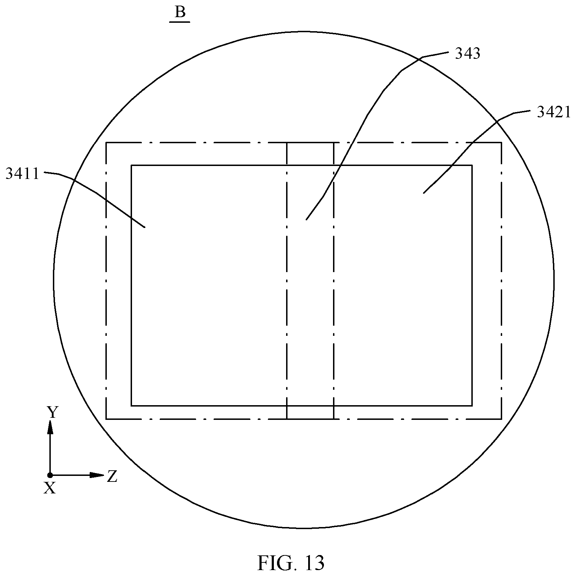

Refer to FIG. 11, FIG. 12, and FIG. 13. FIG. 11 is an enlarged view of a region A in FIG. 10, FIG. 12 is a schematic diagram of a structure of a circuit board according to some embodiments of this application, and FIG. 13 is an enlarged view of a region B in FIG. 12. In some embodiments, the circuit board body 32 includes a first surface 321. The first group of pads 341 and the second group of pads 342 are disposed on the first surface 321. The first group of pads 341 is distributed along a first ring A1, the first group of pads 341 is used for soldering the first shielding case 331, the first group of pads 341 includes first pads 3411, and the first pads 3411 are arranged on an edge that is of the first ring A1 and that is close to the second group of pads 342. The second group of pads 342 is distributed along a second ring A2, the second group of pads 342 is used for soldering the second shielding case 332, the second group of pads 342 includes second pads 3421, and the second pads 3421 are arranged on an edge that is of the second ring A2 and that is close to the first group of pads 341. The first pad 3411 and the second pad 3421 are an integral structural member.

The first ring A1 and the second ring A2 may be circular rings, square rings, or special-shaped rings. The first ring A1 and the second ring A2 in this embodiment of this application may be respectively disposed based on shapes of the first shielding case 331 and the second shielding case 332. In this application, an example in which the pad 34 is a rectangle is used for description. This should not be considered as a special limitation on this application.

The pads 34 configured to be connected to the first shielding case 331 and the second shielding case 332 are disposed as an integral structural member. Therefore, a distance L1 between originally adjacent pads 34 is canceled, so that orthographic projection areas of the first pad 3411 and the second pad 3421 on the circuit board body 32 are smaller. When the pad 34 occupies a smaller area of the circuit board body 32, a larger quantity of electronic components 31 may be mounted on the circuit board body 32 per unit area, or a same quantity of electronic components 31 may be disposed on a smaller circuit board body 32. Therefore, a layout area of the shielding case 33 is further reduced, to facilitate miniaturization and ultra-thin development of the circuit board body 32.

Continue to refer to FIG. 11. The first shielding case 331 includes a first sidewall 3311, and the first sidewall 3311 forms a sidewall that is of the first shielding case 331 and that is close to the second group of pads 342. The first sidewall 3311 includes a first main body portion 3311a and a first flange portion 3311b, and the first flange portion 3311b is located on an outer surface that is of the first main body portion 3311a and that is close to one end of the first pad 3411. The first main body portion 3311a and the first flange portion 3311b are connected to the first pad 3411. The second shielding case 332 includes a second sidewall 3321, and the second sidewall 3321 forms a sidewall that is of the second shielding case 332 and that is close to the first sidewall 3311. The second sidewall 3321 includes a second main body portion 3321a and a second flange portion 3321b, and the second flange portion 3321b is located on an outer surface that is of the second main body portion 3321a and that is close to one end of the second pad 3421. The second main body portion 3321a and the second flange portion 3321b are connected to the second pad 3421.

The first sidewall 3311 is connected to the first pad 3411. Specifically, a soldering material, for example, solder paste, is disposed on the first pad 3411. The first main body portion 3311a and the first flange portion 3311b are bonded and disposed on a surface that is of the first pad 3411 and that is far away from the circuit board body 32, and the soldering material is heated and molten, so that the first main body portion 3311a and the first flange portion 3311b are soldered to the first pad 3411 as a whole, to solder the first shielding case 331 to the circuit board body 32.

Similarly, the second sidewall 3321 is connected to the second pad 3421. Specifically, a soldering material, for example, solder paste, is disposed on the second pad 3421. The second main body portion 3321a and the second flange portion 3321b are bonded and disposed on a surface that is of the second pad 3421 and that is far away from the circuit board body 32, and the soldering material is heated and molten, so that the second main body portion 3321a and the second flange portion 3321b are soldered to the second pad 3421 as a whole, to solder the second shielding case 332 to the circuit board body 32.

Continue to refer to FIG. 11. In some implementations, a connection portion 343 is disposed between the first pad 3411 and the second pad 3421, the connection portion 343 is disposed on the first surface 321, and the first pad 3411, the second pad 3421, and the connection portion 343 are an integral structural member. A region of the connection portion 343 is formed between the first pad 3411 and the second pad 3421. In this way, when the first sidewall 3311 is soldered to the first pad 3411, some solder may be accumulated on a side edge that is of the first flange portion 3311b and that is close to the connection portion 343, and the connection portion 343 provides space for the accumulated solder. Similarly, when the second sidewall 3321 is soldered to the second pad 3421, some solder may be accumulated on a side edge that is of the second flange portion 3321b and that is close to the connection portion 343, and the connection portion 343 provides space for the accumulated solder. The accumulated solder on the first flange portion 3311b helps improve connection strength between the first sidewall 3311 and the first pad 3411. Similarly, the accumulated solder on the second flange portion 3321b helps improve connection strength between the second sidewall 3321 and the second pad 3421.

Continue to refer to FIG. 11. In some implementations, a solder resist layer 3431 is disposed on a surface that is of the connection portion 343 and that faces away from the circuit board body. The solder resist layer 3431 may be covered with green oil or disposed as bare copper. Solder is not prone to be accumulated at the solder resist layer 3431. In a soldering process, solder that is squeezed out is not accumulated at the solder resist layer 3431, and the molten solder flows to the first pad 3411 and the second pad 3421 on two sides of the connection portion 343. Finally, accumulated solder is formed on the side edge of the first flange portion 3311b and the side edge of the second flange portion 3321b. The solder resist layer 3431 is disposed, to help form an accumulated solder effect, so as to further improve the connection strength between the first sidewall 3311 and the first pad 3411 and the connection strength between the second sidewall 3321 and the second pad 3421.

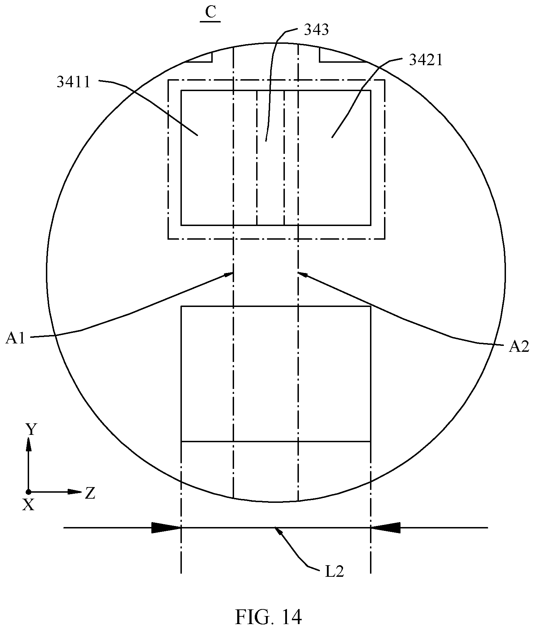

Refer to FIG. 14. FIG. 14 is an enlarged view of a region C in FIG. 12. In some implementations, there are a plurality of first pads 3411 and a plurality of second pads 3421, the plurality of first pads 3411 are distributed at intervals along the edge that is of the first ring A1 and that is close to the second group of pads 342, and the plurality of second pads 3421 are distributed at intervals along the edge that is of the second ring A2 and that is close to the first group of pads 341. A quantity of first pads 3411 is equal to a quantity of second pads 3421, the plurality of first pads 3411 are in a one-to-one correspondence with the plurality of second pads 3421, and a first pad 3411 and a second pad 3421 that correspond to each other are an integral structural member.

There may be two, three, or four first pads 3411 and two, three, or four second pads 3421. This is not specifically limited herein. In this application, an example in which there are two first pads 3411 and two second pads 3421 is used for description. This should not be considered as a special limitation on this application. In an arrangement direction of the first group of pads 341 and the second group of pads 342, orthographic projections of a first pad 3411 and a second pad 3421 that are correspondingly disposed overlap. The plurality of first pads 3411 and the plurality of second pads 3421 are disposed, so that a plurality of connection points can be added to fasten the first shielding case 331 and the second shielding case 332. Specifically, the first shielding case 331 is connected to the plurality of first pads 3411 through the first sidewall 3311, and the second shielding case 332 is connected to the plurality of second pads 3421 through the second sidewall 3321. Strength of connecting the first shielding case 331 and the second shielding case 332 to the circuit board body 32 is improved by implementing connections to the plurality of first pads 3411 and the plurality of second pads 3421.

Continue to refer to FIG. 14. In some embodiments, a whole obtained by connecting the first pad 3411 and the second pad 3421 is a shared pad 34. In the arrangement direction of the first group of pads 341 and the second group of pads 342, a width L2 of the shared pad is greater than or equal to 0.5 mm and less than or equal to 0.9 mm.

In some embodiments, the shared pad is not limited to the first pad 3411 and the second pad 3421, and further includes the connection portion 343 between the first pad 3411 and the second pad 3421. The width L2 of the shared pad is greater than or equal to 0.5 mm, and therefore the shared pad provides a sufficient connection area for the first shielding case 331 and the second shielding case 332, to ensure connection strength between the first shielding case 331 and the first pad 3411 and connection strength between the second shielding case 332 and the second pad 3421. In addition, the width L2 of the shared pad is less than or equal to 0.9 mm, which breaks through an existing limit of 1.05 mm while ensuring connection strength between the first shielding case 331 and the second shielding case 332. This is conducive to miniaturization and thinness and lightness development of the circuit board body 32.

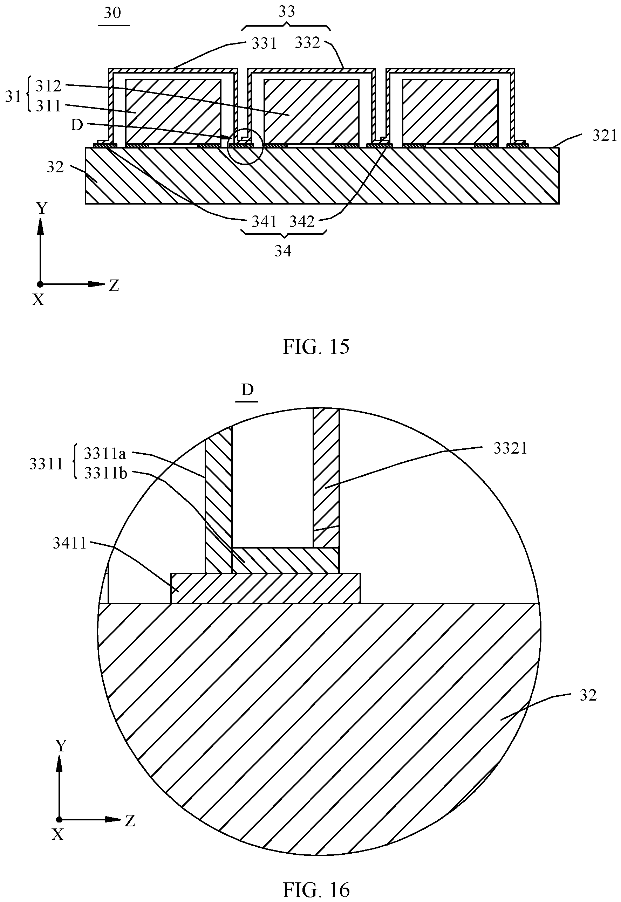

According to a second aspect, refer to FIG. 15 and FIG. 16. FIG. 15 is a schematic diagram of a structure of a circuit board assembly 30 according to some embodiments of this application, and FIG. 16 is an enlarged view of a region D in FIG. 15. In some embodiments, the circuit board assembly 30 includes a circuit board body 32, a first group of pads 341, a second group of pads 342, a first shielding case 331, and a second shielding case 332. The circuit board body 32 includes a first surface 321. The first group of pads 341 and the second group of pads 342 are disposed on the first surface 321. The first group of pads 341 is distributed along a first ring A1, the first group of pads 341 includes first pads 3411, and the first pads 3411 are arranged on an edge that is of the first ring A1 and that is close to the second group of pads 342. The second group of pads 342 and the first pad 3411 are distributed along a second ring A2. The first shielding case 331 includes a first sidewall 3311, and the first sidewall 3311 forms a sidewall that is of the first shielding case 331 and that is close to the second group of pads 342. The first sidewall 3311 includes a first main body portion 3311a and a first flange portion 3311b, and the first flange portion 3311b is located on an outer surface that is of the first main body portion 3311a and that is close to one end of the first pad 3411. The first main body portion 3311a and the first flange portion 3311b are connected to the first pad 3411. The second shielding case 332 includes a second sidewall 3321, and the second sidewall 3321 forms a sidewall that is of the second shielding case 332 and that is close to the first sidewall 3311. The second sidewall 3321 is at least partially located on a side that is of the first flange portion 3311b and that is back-to-back with the first pad 3411, and is at least partially connected to the first flange portion 3311b.

The second shielding case 332 is connected to the first flange portion 3311b of the first shielding case 331 through at least a part of the second sidewall 3321. That is, the second shielding case 332 may be connected to the first flange portion 3311b through a half of the second sidewall 3321, or may be connected to the first flange portion 3311b through the entire second sidewall 3321. The half and the entire second sidewall are examples for description. This should not be considered as a special limitation on this application.

The first shielding case 331 is connected to the first pad 3411 through the first sidewall 3311, and the second shielding case 332 is connected to a surface that is of the first flange portion 3311b and that is far away from the first pad 3411 through the second sidewall 3321. An area that is of the second shielding case 332 and that is soldered to a second pad 3421 is saved, and an original transverse area is converted to a longitudinal direction, that is, an area originally set on an X-Z plane is transferred to an X-Y plane. The first sidewall 3311 and the second sidewall 3321 are connected to the circuit board body 32 only through the first pad 3411. In this way, an area that is of the circuit board body 32 and that is occupied by the pad is reduced. A larger quantity of electronic components 31 may be mounted on the circuit board body 32 per unit area, or a same quantity of electronic components 31 may be disposed on a smaller circuit board body 32. Therefore, a layout area of the shielding case 33 is further reduced, to facilitate miniaturization and ultra-thin development of the circuit board body 32.

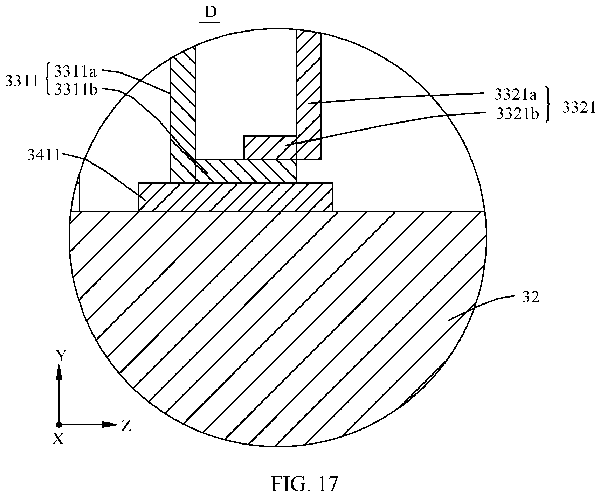

Refer to FIG. 17. FIG. 17 is another enlarged view of a region D in FIG. 15. In some embodiments, the second sidewall 3321 includes a second main body portion 3321a and a second flange portion 3321b, and the second flange portion 3321b is located on an outer surface that is of the second main body portion 3321a and that is close to one end of the first pad 3411. On the second sidewall 3321, the second flange portion 3321b is at least partially located on the side that is of the first flange portion 3311b and that is back-to-back with the first pad 3411, and the second flange portion 3321b is at least partially connected to the first flange portion 3311b.

The second flange portion 3321b is at least partially connected to the first flange portion 3311b of the first shielding case 331. That is, the second shielding case 332 may be connected to the first flange portion 3311b through a half of the second flange portion 3321b, or may be connected to the first flange portion 3311b through the entire second flange portion 3321b. The half and the entire second flange portion are examples for description. This should not be considered as a special limitation on this application.

The second sidewall 3321 is connected to the first sidewall 3311 by connecting the second flange portion 3321b to the first flange portion 3311b. The second flange portion 3321b provides a larger connection area for the connection between the second sidewall 3321 and the first sidewall 3311, to improve connection strength of the second shielding case 332, so that the circuit board assembly 30 has higher stability. The second pad 3421 configured to be connected to the second sidewall 3321 is canceled on the circuit board body 32, and the second sidewall 3321 is directly connected to a surface that is of the first sidewall 3311 and that is far away from the first pad 3411. In this way, an area that is of the circuit board body 32 and that is occupied by the pad 34 is reduced. Therefore, a layout area of the shielding case 33 is further reduced, to facilitate miniaturization and ultra-thin development of the circuit board body 32.

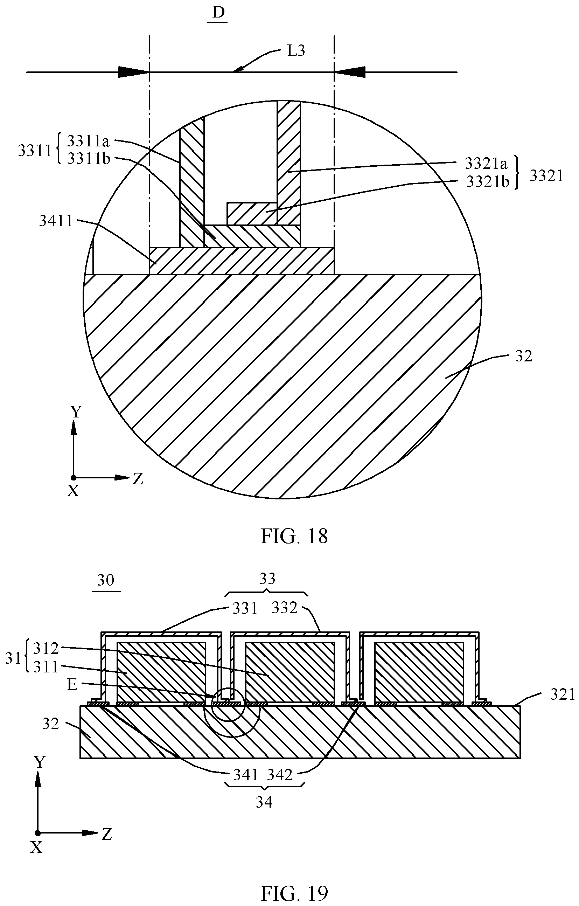

Refer to FIG. 18. FIG. 18 is another enlarged view of a region D in FIG. 15. In some embodiments, both the second main body portion 3321a and the second flange portion 3321b are located on the side that is of the first flange portion 3311b and that is back-to-back with the first pad 3411, and both the second main body portion 3321a and the second flange portion 3321b are connected to the first flange portion 3311b. The second sidewall 3321 is connected to the first sidewall 3311 by connecting both the second main body portion 3321a and the second flange portion 3321b to the first flange portion 3311b. The second main body portion 3321a and the second flange portion 3321b provide a larger connection area for the connection between the second sidewall 3321 and the first sidewall 3311, to improve the connection strength of the second shielding case 332, so that the circuit board assembly 30 has higher stability. This further reduces a layout area of the shielding case 33, to facilitate miniaturization and ultra-thin development of the circuit board body 32.

In some embodiments, there are a plurality of first pads 3411, and the plurality of first pads 3411 are distributed at intervals along the edge that is of the first ring A1 and that is close to the second group of pads 342. There may be two, three, or four first pads 3411. This is not specifically limited herein. In this application, an example in which there are two first pads 3411 is used for description. This should not be considered as a special limitation on this application. The plurality of first pads 3411 are disposed, so that a plurality of connection points can be added to fasten the first shielding case 331. Specifically, the first shielding case 331 is connected to the plurality of first pads 3411 through the first sidewall 3311. Strength of connecting the first shielding case 331 to the circuit board body 32 is improved by implementing a connection to the plurality of first pads 3411. The first sidewall 3311 of the first shielding case 331 provides sufficient connection strength for the second shielding case 332, so that the first shielding case 331 and the second shielding case 332 are more stably fastened.

Continue to refer to FIG. 18. In some embodiments, in an arrangement direction of the first group of pads 341 and the second group of pads 342, that is, in a z-axis direction, a width L3 of the first pad 3411 is greater than or equal to 0.7 mm and less than or equal to 0.85 mm. The width L3 of the first pad 3411 is greater than or equal to 0.7 mm, and therefore the first pad 3411 provides a sufficient connection area for the first sidewall of the first shielding case 331, and is sufficient to meet an extension area that is of the first flange portion 3311b and that is used to be connected to the second sidewall 3321. Therefore, the width L3 of the first pad 3411 may ensure connection strength between the first shielding case 331 and the first pad 3411 and connection strength between the second shielding case 332 and the first flange portion 3311b. The width L3 of the first pad 3411 is less than or equal to 0.85 mm, which breaks through an existing limit of 0.9 mm while ensuring connection strength between the first shielding case 331 and the second shielding case 332. This is conducive to miniaturization and thinness and lightness development of the circuit board body 32.

In a production process, first, the first shielding case 331 is soldered to a surface that is of the first group of pads 341 and that is far away from the circuit board body 32; then, the second shielding case 332 is soldered to a surface that is of the second group of pads 342 and that is far away from the circuit board body 32; and finally, the second flange portion 3321b is soldered to the surface that is of the first flange portion 3311b and that is far away from the first pad 3411. The second flange portion 3321b and the first flange portion 3311b may be connected through laser thermo fusion soldering. Alternatively, tin may be dispensed or sprayed between the second flange portion 3321b and the first flange portion 3311b, and then reflow soldering or laser heating is performed at a position at which tin is dispensed or sprayed, so that the solder tin is molten to connect the second flange portion 3321b to the first flange portion 3311b.

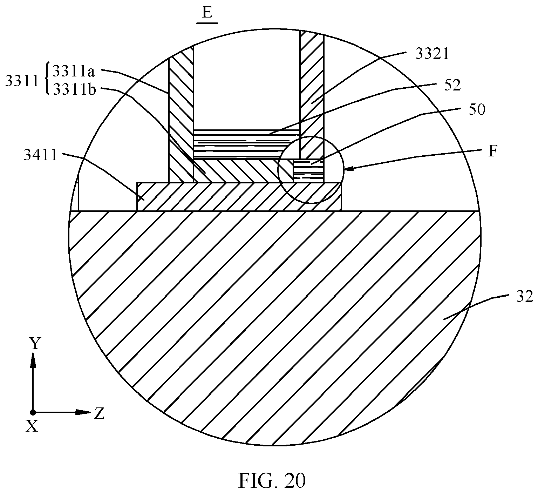

Refer to FIG. 19 and FIG. 20. FIG. 19 is a schematic diagram of a structure of a circuit board assembly 30 according to some embodiments of this application, and FIG. 20 is an enlarged view of a region E in FIG. 19. According to a third aspect, the circuit board assembly 30 includes a circuit board body 32, a first group of pads 341, a second group of pads 342, a first shielding case 331, and a second shielding case 332. The circuit board body 32 includes a first surface 321.

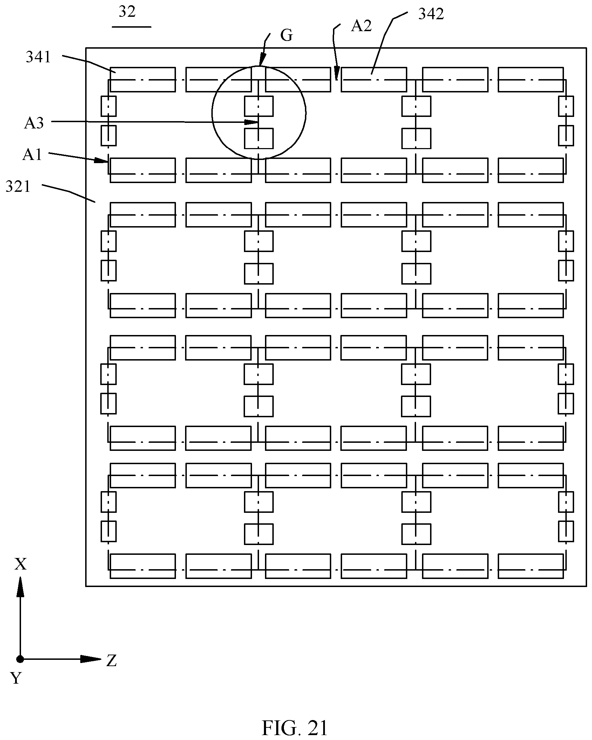

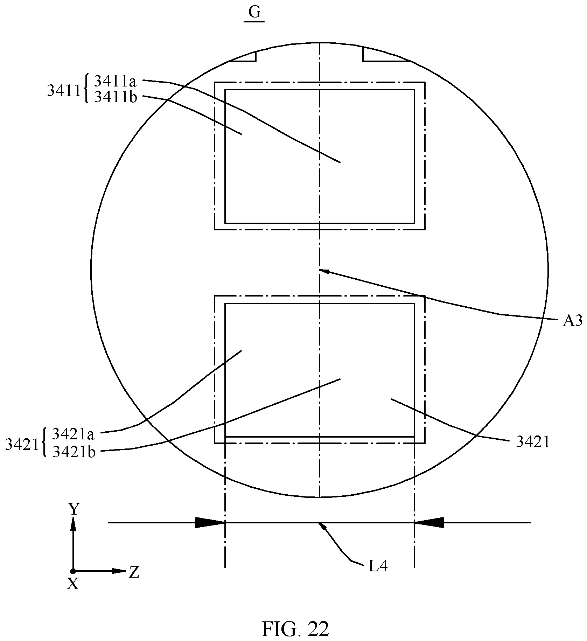

Refer to FIG. 21. FIG. 21 is a schematic diagram of a structure of a circuit board according to some embodiments of this application. The first group of pads 341 and the second group of pads 342 are disposed on the first surface 321, and the first group of pads 341 is distributed along a first ring A1. Refer to FIG. 22. FIG. 22 is an enlarged view of a region G in FIG. 21. The first group of pads 341 includes first pads 3411, and the first pads 3411 are arranged on an edge that is of the first ring A1 and that is close to the second group of pads 342. The second group of pads 342 is distributed along a second ring A2, the second group of pads 342 includes second pads 3421, and the second pads 3421 are arranged on an edge that is of the second ring A2 and that is close to the first group of pads 341. The edge that is of the first ring A1 and that is close to the second group of pads 342 overlaps the edge that is of the second ring A2 and that is close to the first group of pads 341 to form an overlapping edge A3, and the first pads 3411 and the second pads 3421 are alternately disposed along the overlapping edge A3. That is, along the overlapping edge A3, the first pads 3411 and the second pads 3421 are alternately arranged on the overlapping edge A3.

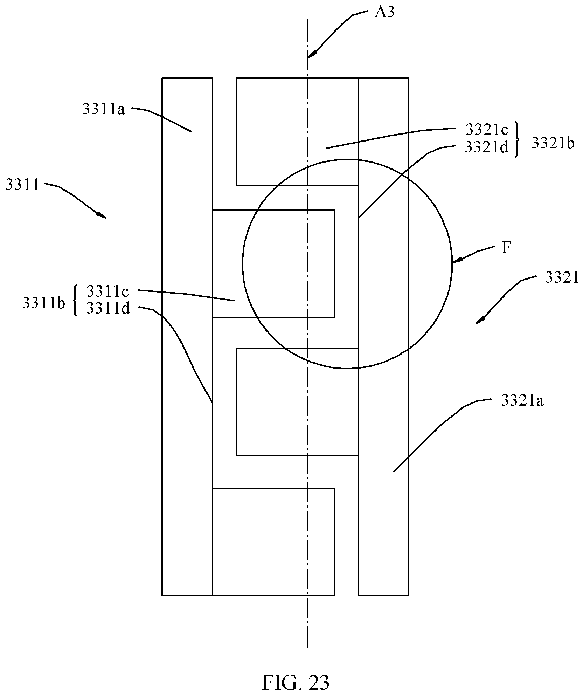

Continue to refer to FIG. 20. The first shielding case 331 includes a first sidewall 3311, and the first sidewall 3311 forms a sidewall that is of the first shielding case 331 and that is close to the second group of pads 342. The first sidewall 3311 includes a first main body portion 3311a and a first flange portion 3311b, and a plurality of first flange portions 3311b are located on an outer surface that is of the first main body portion 3311a and that is close to one end of the first pad 3411. Refer to FIG. 23. FIG. 23 is a schematic diagram of a structure of a first shielding case 331 and a second shielding case 332 according to some embodiments of this application. For ease of understanding, a region F in FIG. 23 is a region F in FIG. 20. The first flange portion 3311b includes first convex portions 3311c and first concave portions 3311d, and the first convex portions 3311c and the first concave portions 3311d are alternately disposed along the overlapping edge A3. In an extension direction of the overlapping edge A3, the first convex portions 3311c and the first concave portions 3311d are alternately disposed on the first flange portion 3311b. The first pad 3411 is at least partially opposite to and connected to the first convex portion 3311c. In a direction perpendicular to the first surface 321, an orthographic projection of the first pad 3411 at least partially overlaps an orthographic projection of the first convex portion 3311c. In addition, overlapping parts of the orthographic projection of the first convex portion 3311c and the orthographic projection of the first pad 3411 are connected.

The second shielding case 332 includes a second sidewall 3321, and the second sidewall 3321 forms a sidewall that is of the second shielding case 332 and that is close to the first group of pads 341. The second sidewall 3321 includes a second main body portion 3321a and a second flange portion 3321b, and a plurality of second flange portions 3321b are located on an outer surface that is of the second main body portion 3321a and that is close to one end of the second pad 3421. The second flange portion 3321b includes second convex portions 3321c and second concave portions 3321d, and the second convex portions 3321c and the second concave portions 3321d are alternately disposed along the overlapping edge. In the extension direction of the overlapping edge, the second convex portions 3321c and the second concave portions 3321d are alternately disposed on the second flange portion 3321b. In addition, the second pad 3421 is at least partially opposite to and connected to the second convex portion 3321c. In the direction perpendicular to the first surface 321, an orthographic projection of the second pad 3421 at least partially overlaps an orthographic projection of the second convex portion 3321c. In addition, overlapping parts of the orthographic projection of the second convex portion 3321c and the orthographic projection of the second pad 3421 are connected.

Sidewalls that are of the first shielding case 331 and the second shielding case 332 and that are located on the overlapping edge A3 are disposed in a concave-convex shape, and the first shielding case 331 and the second shielding case 332 are fastened by connecting the convex portions to the pads 34. Specifically, the first shielding case 331 is connected to the first pad 3411 through the first convex portion 3311c, and the second shielding case 332 is connected to the second pad 3421 through the second convex portion 3321c. In addition, the first pads 3411 and the second pads 3421 are alternately disposed, and a first pad 3411 and a second pad 3421 that originally need to be correspondingly disposed on two sides of the overlapping edge A3 are canceled. Therefore, a total quantity of first pads 3411 and second pads 3421 is reduced. When the pad 34 occupies a smaller area of the circuit board body 32, a larger quantity of electronic components 31 may be mounted on the circuit board body 32 per unit area, or a same quantity of electronic components 31 may be disposed on a smaller circuit board body 32. Therefore, a layout area of the shielding case 33 is further reduced, to facilitate miniaturization and ultra-thin development of the circuit board body 32.

Continue to refer to FIG. 22. In some embodiments, the first pad 3411 includes a first region 3411a and a second region 3411b. The first region 3411a is opposite to and connected to the first convex portion 3311c, and the second region 3411b is opposite to and connected to an edge that is of the second flange portion 3321b and on which the second concave portion 3321d is formed. For ease of understanding, still refer to FIG. 20. The first sidewall is connected to the first region 3411a of the first pad 3411 through the first convex portion 3311c, and the second sidewall 3321 is connected to the second region 3411b of the first pad 3411 through the second concave portion 3321d. That is, the second shielding case 332 is connected to the second pad 3421 through the second convex portion 3321d, and may be further connected to the first pad 3411 through the second concave portion 3321d. A connection area of the second shielding case 332 is further increased, so that the second shielding case 332 is more stably connected, to further improve stability of the circuit board assembly 30. In addition, the second shielding case 332 is connected to the first pad 3411 only through the second concave portion 3321d. In this way, an area that is of the first pad 3411 and that is reserved for being connected to the second shielding case 332 is reduced, and an area that is of the circuit board body 32 and that is occupied by the first pad 3411 is reduced. Therefore, a layout area of the shielding case 33 is further reduced, to facilitate miniaturization and ultra-thin development of the circuit board body 32.

Continue to refer to FIG. 22. In some embodiments, the second pad 3421 includes a third region 3421a and a fourth region 3421b. The third region 3421a is opposite to and connected to the second convex portion 3321c, and the fourth region 3421b is opposite to and connected to an edge that is of the first flange portion 3311b and on which the first concave portion 3311d is formed. The second sidewall 3321 is connected to the third region 3421a of the second pad 3421 through the second convex portion 3321c, and the first sidewall 3311 is connected to the fourth region 3421b of the second pad 3421 through the first concave portion 3311d. That is, the first shielding case 331 is connected to the first pad 3411 through the first convex portion 3311c, and may be further connected to the second pad 3421 through the first concave portion 3311d. A connection area of the first shielding case 331 is further increased, so that the first shielding case 331 is more stably connected, to further improve stability of the circuit board assembly 30. In addition, the first shielding case 331 is connected to the second pad 3421 only through the first concave portion 3311d. In this way, an area that is of the second pad 3421 and that is reserved for being connected to the first shielding case 331 is reduced, and an area that is of the circuit board body 32 and that is occupied by the second pad 3421 is reduced. Therefore, a layout area of the shielding case 33 is further reduced, to facilitate miniaturization and ultra-thin development of the circuit board body 32.

Continue to refer to FIG. 20. In some embodiments, the first concave portion extends to the first main body portion 3311a and runs through the first flange portion 3311b and the first main body portion 3311a; and the second concave portion 3321d extends to the second main body portion 3321a and runs through the second flange portion 3321b and the second main body portion 3321a. In this case, in the direction perpendicular to the first surface 321, a distance between the first concave portion 3311d and the first surface is greater than a height between the first convex portion 3311c and the first surface 321, and a distance between the second concave portion 3321d and the first surface 321 is greater than a height between the second convex portion 3321c and the first surface 321. When the first shielding case 331 and the second shielding case 332 are connected to the circuit board body 32, the first concave portion 3311d may be directly disposed on a surface that is of the second convex portion 3321c and that is far away from the second pad 3421, and the second concave portion 3321d may be directly disposed on a surface that is of the first convex portion 3311c and that is far away from the first pad 3411. A width that is of the first pad 3411 and that is reserved for being connected to the second concave portion 3321d and a width that is of the second pad 3421 and that is reserved for being connected to the first concave portion 3311d are further saved. In this way, the area that is of the circuit board body 32 and that is occupied by each of the first pad 3411 and the second pad 3421 is further reduced. Therefore, a layout area of the shielding case 33 is further reduced, to facilitate miniaturization and ultra-thin development of the circuit board body 32.

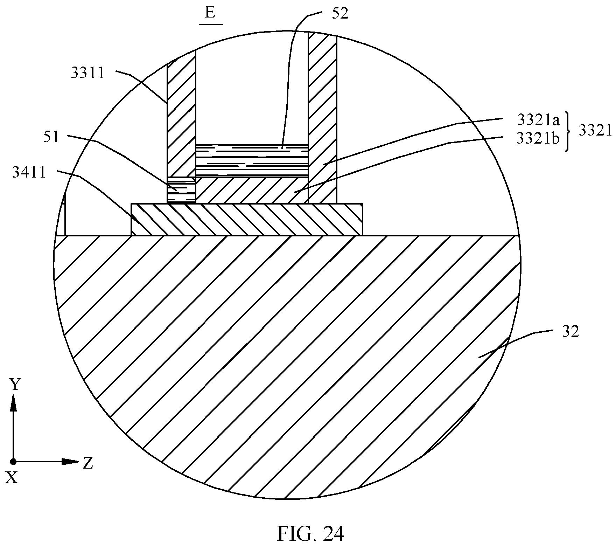

Refer to FIG. 24. FIG. 24 is an enlarged view of a region E in FIG. 19. In some embodiments, a first soldering material 50 is disposed in a part that is of the first concave portion 3311d and that is located between the first main body portion 3311a and the second pad 3421; and a second soldering material 51 is disposed in a part that is of the second concave portion 3321d and that is located between the second main body portion 3321a and the first pad 3411. A gap between the first concave portion 3311d and the second pad 3421 is filled by using the first soldering material 50, and a gap between the second concave portion 3321d and the first pad 3411 is filled by using the second soldering material 51. In this way, closed accommodation cavities are formed in the first shielding case 331 and the second shielding case 332, and a first electronic component 311 and a second electronic component 312 are respectively accommodated in the first shielding case 331 and the second shielding case 332. The closed accommodation cavities formed in the first shielding case 331 and the second shielding case 332 better shield an interference signal, to ensure that the electronic components 31 are not affected by the interference signal.

Continue to refer to FIG. 24. A third soldering material 52 is disposed between the first main body portion 3311a and the second main body portion 3321a. The third soldering material 52 further fills a gap between the first shielding case 331 and the second shielding case 332, to better ensure that the electronic components 31 are not affected by the interference signal.

Continue to refer to FIG. 24. The third soldering material 52 and each of the first soldering material 50 and the second soldering material 51 are an integral structural member. The third soldering material 52 may be a part that is of the first soldering material 50 and that is squeezed between the first main body portion 3311a and the second main body portion 3321a, or may be a part that is of the second soldering material 51 and that is squeezed between the first main body portion 3311a and the second main body portion 3321a. In a production process, a solder spot-coating process needs to be performed only based on this, and the first main body portion 3311a and the second main body portion 3321a do not need to be specifically spot-coated with solder. This is more efficient and faster in a process procedure.

In some embodiments, in an arrangement direction of the first group of pads 341 and the second group of pads 342, a width of the first pad 3411 and a width of the second pad 3421 are greater than or equal to 0.5 mm and less than or equal to 0.9 mm. The width L4 of the first pad 3411 and the width L4 of the second pad 3421 are greater than or equal to 0.5 mm, and therefore the width of the first pad 3411 and the width of the second pad 3421 provide a sufficient connection area for the first shielding case 331 and the second shielding case 332. In addition, the width L4 of the first pad 3411 and the width L4 of the second pad 3421 are less than or equal to 0.9 mm, which breaks through an existing limit of 1.05 mm while ensuring connection strength between the first shielding case 331 and the second shielding case 332. This is conducive to miniaturization and thinness and lightness development of the circuit board body.

In some embodiments, the first soldering material 50, the second soldering material 51, and the third soldering material 52 may be implemented by dispensing tin, spraying spin, or performing coating with shielding adhesive.

In the descriptions of this specification, specific features, structures, materials, or characteristics may be properly combined in any one or more embodiments or examples.

Finally, it should be noted that the foregoing embodiments are only used to describe the technical solutions in this application, but are not used to limit this application. Although this application is described in detail with reference to the foregoing embodiments, it should be understood by a person of ordinary skill in the art that the technical solutions described in the foregoing embodiments may still be modified, or some technical features thereof may be equivalently replaced. These modifications or replacements do not make the essence of the corresponding technical solutions depart from the spirit and scope of the technical solutions in the embodiments of this application.

## Claims

1. A circuit board, comprising:
a circuit board body, comprising a first surface; and
a first group of pads and a second group of pads, wherein the first group of pads and the second group of pads are disposed on the first surface, the first group of pads is distributed along a first ring, the first group of pads is used for soldering a first shielding case, the first group of pads comprises first pads, and the first pads are arranged on an edge that is of the first ring and that is close to the second group of pads, wherein
the second group of pads is distributed along a second ring, the second group of pads is used for soldering a second shielding case, the second group of pads comprises second pads, and the second pads are arranged on an edge that is of the second ring and that is close to the first group of pads; and
the first pad and the second pad are an integral structural member.

2. The circuit board according to claim 1, wherein a connection portion is disposed between the first pad and the second pad, the connection portion is disposed on the first surface, and the first pad, the second pad, and the connection portion are an integral structural member.

3. The circuit board according to claim 2, wherein a solder resist layer is disposed on a surface that is of the connection portion and that faces away from the circuit board body.

4. The circuit board according to any one of claims 1-3, wherein
there are a plurality of first pads and a plurality of second pads, the plurality of first pads are distributed at intervals along the edge that is of the first ring and that is close to the second group of pads, and the plurality of second pads are distributed at intervals along the edge that is of the second ring and that is close to the first group of pads; and
a quantity of first pads is equal to a quantity of second pads, the plurality of first pads are in a one-to-one correspondence with the plurality of second pads, and a first pad and a second pad that correspond to each other are an integral structural member.

5. The circuit board according to any one of claims 1-4, wherein
a whole obtained by connecting the first pad and the second pad is a shared pad; and
in an arrangement direction of the first group of pads and the second group of pads, a width of the shared pad is greater than or equal to 0.5 mm and less than or equal to 0.9 mm.

6. A circuit board assembly, comprising:
a circuit board according to any one of claims 1-5;
a first shielding case, wherein the first shielding case is connected to the first group of pads; and
a second shielding case, wherein the second shielding case is connected to the second group of pads.

7. A circuit board assembly, comprising:
a circuit board body, comprising a first surface;
a first group of pads and a second group of pads, wherein the first group of pads and the second group of pads are disposed on the first surface, the first group of pads is distributed along a first ring, the first group of pads comprises first pads, and the first pads are arranged on an edge that is of the first ring and that is close to the second group of pads, wherein
the second group of pads and the first pad are distributed along a second ring;
a first shielding case, wherein the first shielding case comprises a first sidewall, and the first sidewall forms a sidewall that is of the first shielding case and that is close to the second group of pads; the first sidewall comprises a first main body portion and a first flange portion, and the first flange portion is located on an outer surface that is of the first main body portion and that is close to one end of the first pad; and the first main body portion and the first flange portion are connected to the first pad; and
a second shielding case, wherein the second shielding case comprises a second sidewall, and the second sidewall forms a sidewall that is of the second shielding case and that is close to the first sidewall; and the second sidewall is at least partially located on a side that is of the first flange portion and that is back-to-back with the first pad, and the second sidewall is at least partially connected to the first flange portion.

8. The circuit board assembly according to claim 7, wherein the second sidewall comprises a second main body portion and a second flange portion, and the second flange portion is located on an outer surface that is of the second main body portion and that is close to one end of the first pad; and
on the second sidewall, the second flange portion is at least partially located on the side that is of the first flange portion and that is back-to-back with the first pad, and the second flange portion is at least partially connected to the first flange portion.

9. The circuit board assembly according to claim 8, wherein both the second main body portion and the second flange portion are located on the side that is of the first flange portion and that is back-to-back with the first pad, and both the second main body portion and the second flange portion are connected to the first flange portion.

10. The circuit board assembly according to any one of claims 7-9, wherein there are a plurality of first pads, and the plurality of first pads are distributed at intervals along the edge that is of the first ring and that is close to the second group of pads.

11. The circuit board assembly according to any one of claims 7-10, wherein in an arrangement direction of the first group of pads and the second group of pads, a width of the first pad is greater than or equal to 0.7 mm and less than or equal to 0.85 mm.

12. A circuit board assembly, comprising:
a circuit board body, comprising a first surface;
a first group of pads and a second group of pads, wherein the first group of pads and the second group of pads are disposed on the first surface, the first group of pads is distributed along a first ring, the first group of pads comprises first pads, and the first pads are arranged on an edge that is of the first ring and that is close to the second group of pads, wherein
the second group of pads is distributed along a second ring, the second group of pads comprises second pads, and the second pads are arranged on an edge that is of the second ring and that is close to the first group of pads; and
the edge that is of the first ring and that is close to the second group of pads overlaps the edge that is of the second ring and that is close to the first group of pads to form an overlapping edge, and the first pads and the second pads are alternately disposed along the overlapping edge;
a first shielding case, wherein the first shielding case comprises a first sidewall, and the first sidewall forms a sidewall that is of the first shielding case and that is close to the second group of pads; the first sidewall comprises a first main body portion and a first flange portion, and a plurality of first flange portions are located on an outer surface that is of the first main body portion and that is close to one end of the first pad; and the first flange portion comprises first convex portions and first concave portions, the first convex portions and the first concave portions are alternately disposed along the overlapping edge, and the first pad is at least partially opposite to and connected to the first convex portion; and
a second shielding case, wherein the second shielding case comprises a second sidewall, and the second sidewall forms a sidewall that is of the second shielding case and that is close to the first group of pads; the second sidewall comprises a second main body portion and a second flange portion, and a plurality of second flange portions are located on an outer surface that is of the second main body portion and that is close to one end of the second pad; and the second flange portion comprises second convex portions and second concave portions, the second convex portions and the second concave portions are alternately disposed along the overlapping edge, and the second pad is at least partially opposite to and connected to the second convex portion.

13. The circuit board assembly according to claim 12, wherein
the first pad comprises a first region and a second region; and
the first region is opposite to and connected to the first convex portion, and the second region is opposite to and connected to an edge that is of the second flange portion and on which the second concave portion is formed.

14. The circuit board assembly according to claim 12 or 13, wherein
the second pad comprises a third region and a fourth region; and
the third region is opposite to and connected to the second convex portion, and the fourth region is opposite to and connected to an edge that is of the first flange portion and on which the first concave portion is formed.

15. The circuit board assembly according to any one of claims 12-14, wherein
the first concave portion extends to the first main body portion and runs through the first flange portion and the first main body portion; and
the second concave portion extends to the second main body portion and runs through the second flange portion and the second main body portion.

16. The circuit board assembly according to any one of claims 12-15, wherein
a first soldering material is disposed in a part that is of the first concave portion and that is located between the first main body portion and the second pad; and
a second soldering material is disposed in a part that is of the second concave portion and that is located between the second main body portion and the first pad.

17. The circuit board assembly according to any one of claims 12-16, wherein a third soldering material is disposed between the first main body portion and the second main body portion.

18. The circuit board assembly according to claim 17, wherein the third soldering material and each of the first soldering material and the second soldering material are an integral structural member.

19. The circuit board assembly according to any one of claims 12-18, wherein
in an arrangement direction of the first group of pads and the second group of pads, a width of the first pad and a width of the second pad are greater than or equal to 0.5 mm and less than or equal to 0.9 mm.

20. An electronic device, comprising:
a housing; and
the circuit board assembly according to any one of claims 6-19, wherein the circuit board assembly is disposed in the housing.
